# EUROPEAN PATENT APPLICATION

(11) **EP 1 801 649 A2**
(43) Date of publication of application: **27.06.2007**
(21) Application number: 06256367.1
(22) Date of filing: 14.12.2006
(51) Int. Cl.: G03F 7/00

(54) **Imprint lithography**

(30) Priority: 21.12.2005 US 312658
(71) Applicant: ASML Netherlands B.V., 5504 DR Veldhoven (NL)
(72) Inventor: Wuister, Sander Frederik, 5627 CW Eindhoven (NL); Dijksman, Johan Frederik, 6002 VM Weert (NL); Kruijt-Stegeman, Yvonne Wendela, 5641 HE Eindhoven (NL)
(74) Representative: Roberts, Peter David

(57) **Abstract**

A lithographic apparatus is disclosed that comprises a template holder configured to hold a plurality of imprint templates, and a substrate holder configured to hold a substrate, the template holder being located beneath the substrate holder.

## Description

### 1. FIELD

The present invention relates to imprint lithography.

### 2. BACKGROUND

A lithographic apparatus is a machine that applies a desired pattern onto a target portion of a substrate. Lithographic apparatus are conventionally used, for example, in the manufacture of integrated circuits (ICs), flat panel displays and other devices involving fine structures.

It is desirable to reduce the size of features in a lithographic pattern because this allows for a greater density of features on a given substrate area. In photolithography, the increased resolution may be achieved by using radiation of shorter wavelength. However, there are problems associated with such reductions. Current systems are starting to adopt optical sources with wavelengths in the 193 nm regime but even at this level, diffraction limitations become a barrier. At lower wavelengths, the transparency of materials is very poor. Optical lithography machines capable of enhanced resolutions require complex optics and rare materials and are consequently very expensive.

An alternative for printing sub-100nm features, known as imprint lithography, comprises transferring a pattern to a substrate by imprinting a pattern into an imprintable medium using a physical mould or template. The imprintable medium may be the substrate or a material coated on to a surface of the substrate. The imprintable medium may be functional or may be used as a "mask" to transfer a pattern to an underlying surface. The imprintable medium may, for instance, be provided as a resist deposited on a substrate, such as a semiconductor material, into which the pattern defined by the template is to be transferred. Imprint lithography is thus essentially a moulding process on a micrometer or nanometer scale in which the topography of a template defines the pattern created on a substrate. Patterns may be layered as with optical lithography processes so that, in principle, imprint lithography could be used for such applications as IC manufacture.

The resolution of imprint lithography is limited only by the resolution of the template fabrication process. For instance, imprint lithography may be used to produce features in the sub-50 nm range with significantly improved resolution and line edge roughness compared to that achievable with conventional optical lithography processes. In addition, imprint processes do not require expensive optics, advanced illumination sources or specialized resist materials typically required by optical lithography processes.

Current imprint lithography processes can have one or more drawbacks as will be mentioned below, particularly with regard to achieving overlay accuracy and/or high throughput. However, significant improvement in resolution and line edge roughness attainable from imprint lithography is a strong driver for addressing those and other problems.

Typically, during imprint lithography the imprintable medium is ink-jet printed onto a substrate, following which a template is pressed into the imprintable medium. A problem which may arise is that some of the imprintable medium evaporates from the substrate before it is imprinted by the template.

### 3. SUMMARY

According to a first aspect of the invention, there is provided a lithographic apparatus comprising a template holder configured to hold a plurality of imprint templates and a substrate holder configured to hold a substrate, wherein the template holder is located beneath the substrate holder.

According to a second aspect of the invention, there is provided a lithographic apparatus comprising a template holder configured to hold a plurality of imprint templates and a substrate holder configured to hold a substrate, wherein the template holder is arranged such that when the imprint templates are held in the template holder an upper surface of the imprint templates remains exposed.

According to a third aspect of the invention, there is provided a lithographic apparatus comprising a template holder configured to hold a plurality of imprint templates and one or more dispensers arranged to dispense a fluid onto the plurality of imprint templates.

According to a fourth aspect of the invention, there is provided a method of imprint lithography comprising applying an imprintable medium to patterned surfaces of a plurality of imprint templates and then contacting the imprint templates against a substrate, such that the imprintable medium is transferred to the substrate.

According to a fifth aspect of the invention, there is provided a lithographic apparatus comprising a template holder configured to hold a plurality of imprint templates, the template holder being arranged such that uppermost surfaces of the imprint templates, when held in the template holder, lie substantially in the same plane.

According to a sixth aspect of the invention there is provided a lithographic apparatus, comprising a template holder configured to hold a plurality of imprint templates; a substrate holder configured to hold a substrate; and a plurality of punches which are associated with respective imprint templates, wherein each punch is dimensioned such that it would punch around an area which is larger than the area of the imprint template with which it is associated.

According to a seventh aspect of the invention, there is provided a method of imprint lithography, comprising applying an imprintable medium to patterned surfaces of a plurality of imprint templates and to an imprint template holder which holds the plurality of imprint templates; allowing the imprintable medium to become substantially solid; using punches to cut through the substantially solid imprintable medium, the punches being arranged to cut through the imprintable medium along a periphery which falls outside of the periphery of each imprint template; and contacting the imprint templates against a substrate.

According to an eighth aspect of the invention there is provided a lithographic apparatus, comprising: a template holder configured to hold a plurality of imprint templates; a substrate holder configured to hold a substrate; a source of actinic radiation; and a radiation guiding apparatus arranged to direct the actinic radiation through the template holder without directing the actinic radiation through the imprint templates.

According to a ninth aspect of the invention there is provided a method of imprint lithography, comprising applying an imprintable medium to a patterned surface of an imprint template; applying a cyanoacrylate to a surface of a substrate; and contacting the imprint template against the substrate, such that the cyanoacrylate induces polymerization of the imprintable medium.

According to a tenth aspect of the invention, there is provided a method of imprint lithography, comprising: applying a polymer and a solvent to a patterned surface of an imprint template; allowing the solvent to evaporate such that the polymer becomes solid; applying a layer of monomer to a substrate; contacting the imprint template against the substrate such that the polymer is pushed against the monomer layer; and after contacting, illuminating the monomer layer with actinic radiation.

According to an eleventh aspect of the invention, there is provided a method of imprint lithography, comprising: applying a mixture of monomer and polymer to a patterned surface of an imprint template; contacting the imprint template against a substrate; and after contacting, illuminating the mixture of monomer and polymer with actinic radiation.

According to a twelfth aspect of the invention, there is provided a method of imprint lithography, comprising: applying an imprintable medium to a patterned surface of an imprint template; applying a planarization layer to a surface of a substrate, both the imprintable medium and the planarization layer being fluids; and after the applying, contacting the imprint template against the substrate.

One or more embodiments of the present invention are applicable to any imprint lithography process in which a patterned template is imprinted into an imprintable medium in a flowable state, and for instance can be applied to hot and UV imprint lithography as described above. For the purpose of understanding one or more embodiments of the present invention, it is not necessary to describe the imprint process in any more detail than has already been given and is known in the art.

### 4. BRIEF DESCRIPTION OF THE DRAWINGS

Embodiments of the invention will now be described, by way of example only, with reference to the accompanying schematic drawings in which corresponding reference symbols indicate corresponding parts, and in which:

Figure 1a - 1c illustrate examples of conventional soft, hot and UV lithography processes respectively;

Figure 2 illustrates a two step etching process employed when hot and UV imprint lithography is used to pattern a resist layer;

Figure 3 schematically illustrates a template and a typical imprintable resist layer deposited on a substrate;

Figure 4a - 4c schematically shows an imprint lithographic apparatus according to an embodiment of the invention;

Figures 5a - 5c schematically illustrates a property of an embodiment of the invention; and

Figures 6a to 14f schematically illustrate embodiments of the invention.

### 5. DETAILED DESCRIPTION

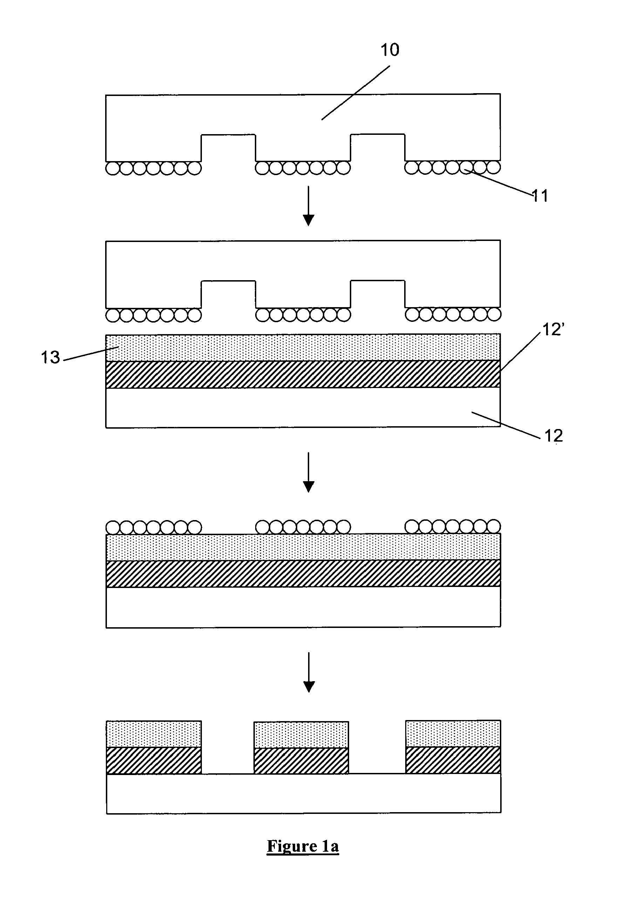

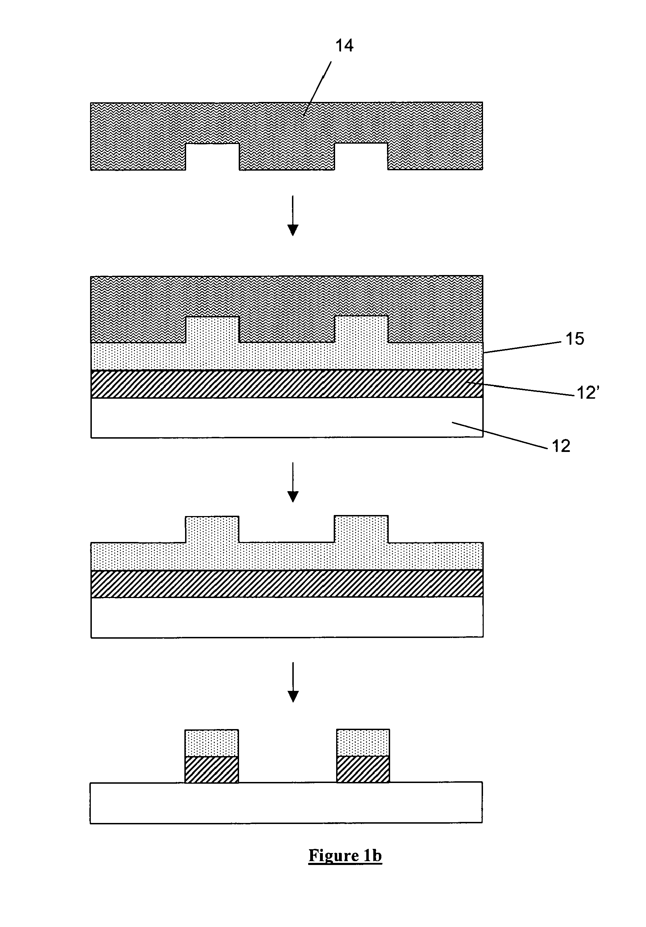

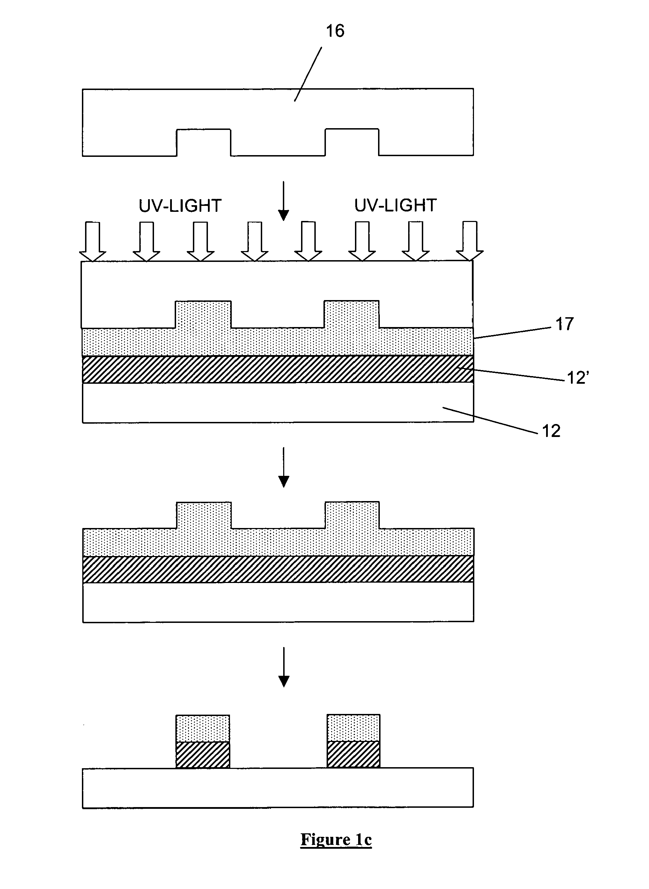

There are two principal approaches to imprint lithography which will be termed generally as hot imprint lithography and UV imprint lithography. There is also a third type of "printing" lithography known as soft lithography. Examples of these are illustrated in Figures 1a to 1c.

Figure 1a schematically depicts the soft lithography process which involves transferring a layer of molecules 11 (typically an ink such as a thiol) from a flexible template 10 (typically fabricated from polydimethylsiloxane (PDMS)) onto a resist layer 13 which is supported upon a substrate 12 and planarization and transfer layer 12'. The template 10 has a pattern of features on its surface, the molecular layer being disposed upon the features. When the template is pressed against the resist layer, the layer of molecules 11 stick to the resist. Upon removal of the template from the resist, the layer of molecules 11 stick to the resist, the residual layer of resist is etched such that the areas of the resist not covered by the transferred molecular layer are etched down to the substrate.

The template used in soft lithography may be easily deformed and may therefore not be suited to high resolution applications, e.g. on a nanometer scale, since the deformation of the template may adversely affect the imprinted pattern. Furthermore, when fabricating multiple layer structures, in which the same region will be overlaid multiple times, soft imprint lithography may not provide overlay accuracy on a nanometer scale.

Hot imprint lithography (or hot embossing) is also known as nanoimprint lithography (NIL) when used on a nanometer scale. The process uses a harder template made from, for example, silicon or nickel, which are more resistant to wear and deformation. This is described for instance in United States Patent No. 6,482,742 and illustrated in Figure 1b. In a typical hot imprint process, a solid template 14 is imprinted into a thermosetting or a thermoplastic polymer resin 15, which has been cast on the surface of a substrate 12. The resin may, for instance, be spin coated and baked onto the substrate surface or more typically (as in the example illustrated) onto a planarization and transfer layer 12'. It should be understood that the term "hard" when describing an imprint template includes materials which may generally be considered between "hard" and "soft" materials, such as for example "hard" rubber. The suitability of a particular material for use as an imprint template is determined by its application requirements.

When a thermosetting polymer resin is used, the resin is heated to a temperature such that, upon contact with the template, the resin is sufficiently flowable to flow into the pattern features defined on the template. The temperature of the resin is then increased to thermally cure (e.g. crosslink) the resin so that it solidifies and irreversibly adopts the desired pattern. The template may then be removed and the patterned resin cooled.

Examples of thermoplastic polymer resins used in hot imprint lithography processes are poly (methyl methacrylate), polystyrene, poly (benzyl methacrylate) or poly (cyclohexyl methacrylate). The thermoplastic resin is heated so that it is in a freely flowable state immediately prior to imprinting with the template. It is typically necessary to heat thermoplastic resin to a temperature considerably above the glass transition temperature of the resin. The template is pressed into the flowable resin and sufficient pressure is applied to ensure the resin flows into all the pattern features defined on the template. The resin is then cooled to below its glass transition temperature with the template in place whereupon the resin irreversibly adopts the desired pattern. The pattern will consist of the features in relief from a residual layer of the resin which may then be removed by an appropriate etch process to leave only the pattern features.

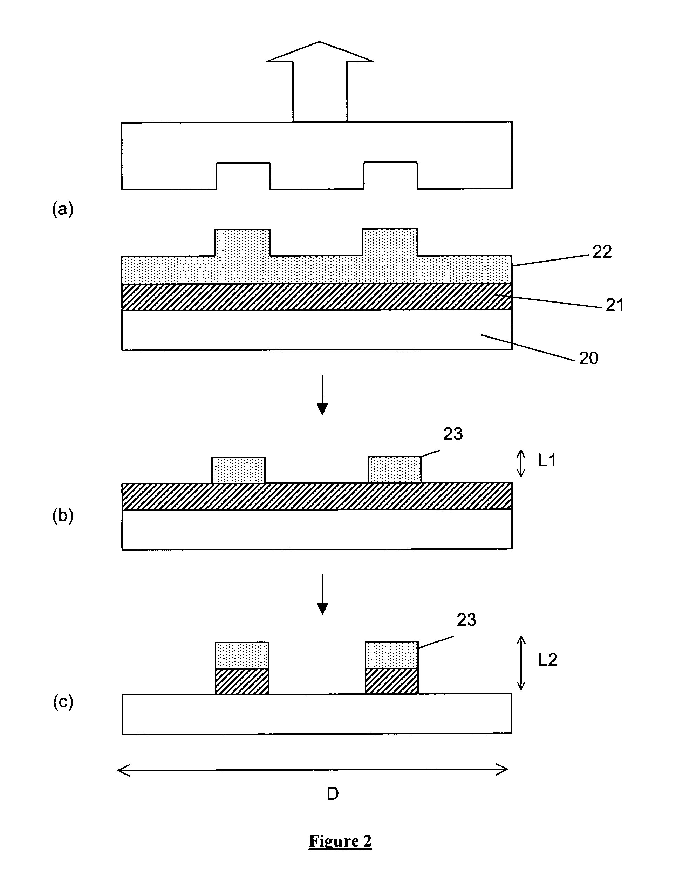

Upon removal of the template from the solidified resin, a two-step etching process is typically performed as illustrated in Figures 2a to 2c. The substrate 20 has a planarization and transfer layer 21 immediately upon it, as schematically shown in Figure 2a. The purpose of the planarization and transfer layer is twofold. It acts to provide a surface substantially parallel to that of the template, which helps ensure that the contact between the template and the resin is parallel, and also to improve the aspect ratio of the printed features, as described herein.

After the template has been removed, a residual layer 22 of the solidified resin is left on the planarization and transfer layer 21, shaped in the desired pattern. The first etch is isotropic and removes parts of the residual layer 22, resulting in a poor aspect ratio of features where L1 is the height of the features 23, as schematically shown in Figure 2b. The second etch is anisotropic (or selective) and improves the aspect ratio. The anisotropic etch removes those parts of the planarization and transfer layer 21 which are not covered by the solidified resin, increasing the aspect ratio of the features 23 to (L2/D), as schematically shown in Figure 2c. The resulting polymer thickness contrast left on the substrate after etching can be used as for instance a mask for dry etching if the imprinted polymer is sufficiently resistant, for instance as a step in a lift-off process.

Hot imprint lithography suffers from a disadvantage in that not only is the pattern transfer performed at a higher temperature, but also relatively large temperature differences might be required in order to ensure the resin is adequately solidified before the template is removed. Temperature differences between 35 and 100°C may be needed. Differential thermal expansion between, for instance, the substrate and template may then lead to distortion in the transferred pattern. This may be exacerbated by the relatively high pressure needed for the imprinting step, due the viscous nature of the imprintable material, which can induce mechanical deformation in the substrate, again distorting the pattern.

UV imprint lithography, on the other hand, does not involve such high temperatures and temperature changes nor does it require such viscous imprintable materials. Rather, UV imprint lithography involves the use of a partially or wholly transparent template and a UV-curable liquid, typically a monomer such as an acrylate or methacrylate. for example. UV imprint lithography is discussed, for example, in J. Haisma "Mold-assisted nanolithography: A process for reliable pattern replication", J. Vac. Sci. Technol. B 14(6), Nov/Dec 1996. In general, any photopolymerizable material could be used, such as a mixture of monomers and an initiator. The curable liquid may also, for instance, include a dimethyl siloxane derivative. Such materials are less viscous than the thermosetting and thermoplastic resins used in hot imprint lithography and consequently move much faster to fill template pattern features. Low temperature and low pressure operation also favors higher throughput capabilities. Although the name 'UV imprint lithography' implies that UV radiation is always used, those skilled in the art will be aware that any suitable actinic radiation may be used (for example, visible light may be used). Hence, any reference herein to UV imprint lithography, UV radiation, UV curable materials, etc. should be interpreted as including any suitable actinic radiation, and should not be interpreted as being limited to UV radiation only.

An example of a UV imprint process is illustrated in Figure 1c. A quartz template 16 is applied to a UV curable resin 17 in a similar manner to the process of Figure 1b. Instead of raising the temperature as in hot embossing employing thermosetting resins, or temperature cycling when using thermoplastic resins, UV radiation is applied to the resin through the quartz template in order to polymerize and thus cure it. Upon removal of the template, the remaining steps of etching the residual layer of resist are the same or similar as for the hot embossing process described herein. The UV curable resins typically used have a much lower viscosity than typical thermoplastic resins so that lower imprint pressures can be used. Reduced physical deformation due to the lower pressures, together with reduced deformation due to high temperatures and temperature changes, makes UV imprint lithography suited to applications requiring high overlay accuracy. In addition, the transparent nature of UV imprint templates can accommodate optical alignment techniques simultaneously to the imprinting.

Although this type of imprint lithography mainly uses UV curable materials, and is thus generically referred to as UV imprint lithography, other wavelengths of radiation may be used to cure appropriately selected materials (e.g., activate a polymerization or cross linking reaction). In general, any radiation capable of initiating such a chemical reaction may be used if an appropriate imprintable material is available. Alternative "activating radiation" may, for instance, include visible light, infrared radiation, x-ray radiation and electron beam radiation. In the general description herein, references to UV imprint lithography and use of UV radiation are not intended to exclude these and other activating radiation possibilities.

As an alternative to imprint systems using a planar template which is maintained substantially parallel to the substrate surface, roller imprint systems have been developed. Both hot and UV roller imprint systems have been proposed in which the template is formed on a roller but otherwise the imprint process is very similar to imprinting using a planar template. Unless the context requires otherwise, references to an imprint template include references to a roller template.

There is a particular development of UV imprint technology known as step and flash imprint lithography (SFIL) which may be used to pattern a substrate in small steps in a similar manner to optical steppers conventionally used, for example, in IC manufacture. This involves printing small areas of the substrate at a time by imprinting a template into a UV curable resin, 'flashing' UV radiation through the template to cure the resin beneath the template, removing the template, stepping to an adjacent region of the substrate and repeating the operation. The small field size of such step and repeat processes may help reduce pattern distortions and CD variations so that SFIL may be particularly suited to manufacture of IC and other devices requiring high overlay accuracy. United States patent application publication US 2004-0124566 describes in detail an example of a step and flash imprint lithography apparatus.

Although in principle the UV curable resin can be applied to the entire substrate surface, for instance by spin coating, this may be problematic due to the volatile nature of UV curable resins.

One approach to addressing this problem is the so-called 'drop on demand' process in which the resin is dispensed onto a target portion of the substrate in droplets immediately prior to imprinting with the template. The liquid dispensing is controlled so that a certain volume of liquid is deposited on a particular target portion of the substrate. The liquid may be dispensed in a variety of patterns and the combination of carefully controlling liquid volume and placement of the pattern can be employed to confine patterning to the target area.

Dispensing the resin on demand as mentioned is not a trivial matter. The size and spacing of the droplets are carefully controlled to ensure there is sufficient resin to fill template features while at the same time minimizing excess resin which can be rolled to an undesirably thick or uneven residual layer since as soon as neighboring drops touch fluid, the resin will have nowhere to flow.

Although reference is made herein to depositing UV curable liquids onto a substrate, the liquids could also be deposited on the template and in general the same techniques and considerations will apply.

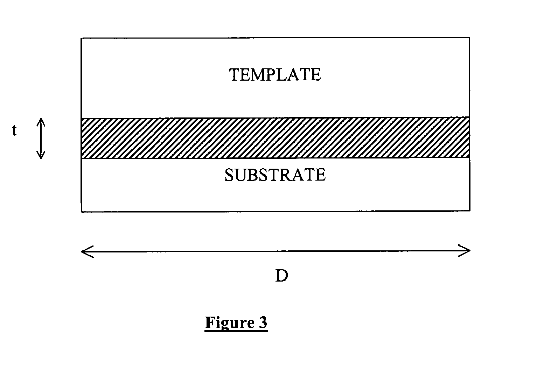

Figure 3 illustrates the relative dimensions of the template, imprintable material (curable monomer, thermosetting resin, thermoplastic, etc) and substrate. The ratio of the width of the substrate, D, to the thickness of the curable resin layer, t, is of the order of 10⁶. It will be appreciated that, in order to avoid the features projecting from the template damaging the substrate, the dimension t should be greater than the depth of the projecting features on the template.

The residual layer left after stamping is useful in protecting the underlying substrate, but as mentioned herein it may also be the source of a problem, particularly when high resolution and/or minimum CD (critical dimension) variation is desired. The first 'breakthrough' etch is isotropic (non-selective) and will thus to some extent erode the features imprinted as well as the residual layer. This may be exacerbated if the residual layer is overly thick and/or uneven. This problem may, for instance, lead to variation in the thickness of lines ultimately formed in the underlying substrate (i.e. variation in the critical dimension). The uniformity of the thickness of a line that is etched in the transfer layer in the second anisotropic etch is dependant upon the aspect ratio and integrity of the shape of the feature left in the resin. If the residual resin layer is uneven, then the non-selective first etch can leave some of these features with "rounded" tops so that they are not sufficiently well defined to ensure good uniformity of line thickness in the second and any subsequent etch process. In principle, the above problem may be reduced by ensuring the residual layer is as thin as possible but this can require application of undesirably large pressures (possibly increasing substrate deformation) and relatively long imprinting times (possibly reducing throughput).

The template is a significant component of the imprint lithography system. As noted herein, the resolution of the features on the template surface is a limiting factor on the attainable resolution of features printed on the substrate. The templates used for hot and UV lithography are generally formed in a two-stage process. Initially, the desired pattern is written using, for example, electron beam writing (e.g., with an electron beam pattern generator), to give a high resolution pattern in resist. The resist pattern is then transferred into a thin layer of chrome which forms the mask for the final, anisotropic etch step to transfer the pattern into the base material of the template. Other techniques such as for example ion-beam lithography, X-ray lithography, extreme UV lithography, epitaxial growth, thin film deposition, chemical etching, plasma etching, ion etching or ion milling could be used. Generally, a technique capable of very high resolution will be used as the template is effectively a 1x mask with the resolution of the transferred pattern being limited by the resolution of the pattern on the template.

The release characteristics of the template may also be a consideration. The template may, for instance, be treated with a surface treatment material to form a thin release layer on the template having a low surface energy (a thin release layer may also be deposited on the substrate).

Another consideration in the development of imprint lithography is the mechanical durability of the template. The template may be subjected to large forces during stamping of the resist, and in the case of hot lithography, may also be subjected to extremes of pressure and temperature. This may cause wearing of the template, and may adversely affect the shape of the pattern imprinted upon the substrate.

In hot imprint lithography, there is a potential advantage in using a template of the same or similar material to the substrate to be patterned in order to reduce differential thermal expansion between the two. In UV imprint lithography, the template is at least partially transparent to the activation radiation and accordingly quartz templates are used.

Although specific reference may be made in this text to the use of imprint lithography in the manufacture of ICs, it should be understood that imprint apparatus and methods described may have other applications, such as the manufacture of integrated optical systems, guidance and detection patterns for magnetic domain memories, hard disc magnetic media, flat panel displays, thin-film magnetic heads, etc.

While in the description herein, particular reference has been made to the use of imprint lithography to transfer a template pattern to a substrate via an imprintable resin effectively acting as a resist, in some circumstances the imprintable material may itself be a functional material, for instance having a functionally such as electrical or thermal conductivity, optical linear or non-linear response, among others. For example, the functional material may form a conductive layer, a semi-conductive layer, a dielectric layer or a layer having another desirable mechanical, electrical or optical property. Some organic substances may also be appropriate functional materials. Such applications may be within the scope an embodiment of the present invention.

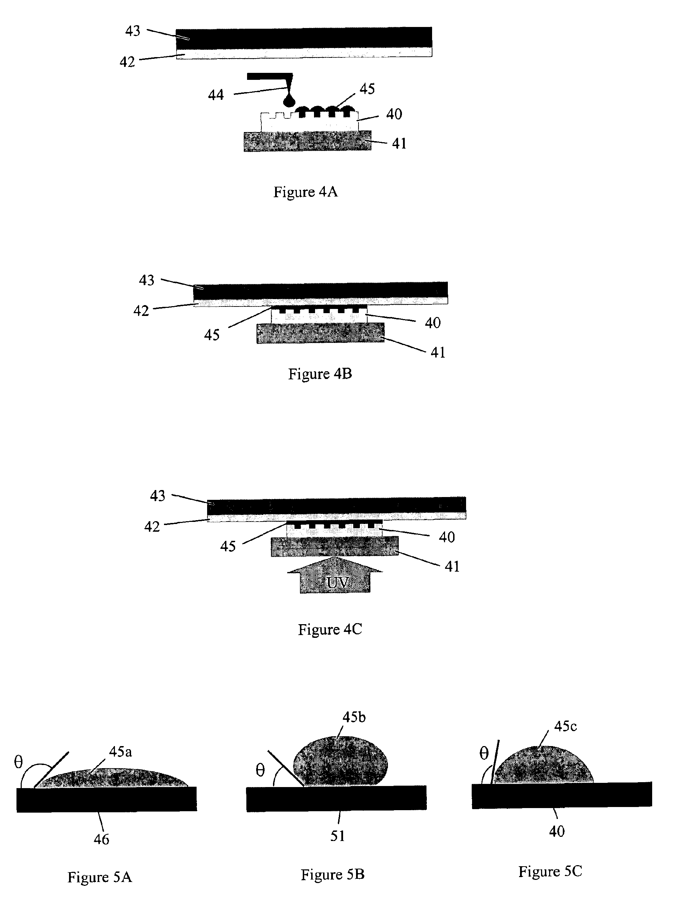

Figure 4A shows schematically an imprint lithography apparatus comprising an imprint template 40 held in a template holder 41, and a substrate 42 held on a substrate table 43. In contrast to a conventional imprint lithography apparatus, the imprint template 40 is located below the substrate table 43 and substrate 42. The substrate 42 is securely fixed to the substrate table 43 by a vacuum provided at the surface of the substrate table. An ink-jet nozzle 44 is arranged to provide droplets of imprintable medium 45 on the imprint template 40 (multiple ink-jet nozzles may be used). This is in contrast to a conventional imprint lithography apparatus, in which imprintable medium is provided on the substrate and not on the imprint template.

The entire surface of the imprint template 40, or at least that area which is provided with a pattern to be imprinted into the substrate 42, is covered with droplets of imprintable medium 45. Although Figure 4A shows the droplets 45 as being in contact with one another, the droplets may instead be separated from one another.

Due to the material properties of the imprint template 40, as compared to the material properties of the substrate 42, evaporation of the imprintable medium 45 may be less than would have been the case if the imprintable medium 45 were to be provided on the substrate 42. The material properties will be discussed further below.

Referring to Figure 4B, the imprint template 40 is moved upwards (and/or the substrate is moved downwards) until the imprint template is in contact with, and pressing against, the substrate 42. This causes the imprintable medium 45 to flow into recesses which form a pattern on the imprint template 40. The imprint template 40 is held in this position until substantially all recesses of the imprint template have been filled by imprintable medium 45. Following this, as schematically shown in Figure 4C, actinic radiation (for example, UV radiation or visible light) is directed at the imprintable medium 45. The actinic radiation passes through the imprint template 40, which is transparent at the wavelength or wavelengths used, and is absorbed by the imprintable medium 45. The imprintable medium is cured by the actinic radiation with the effect that, once the imprint template 40 is removed, the imprintable medium 45 retains the pattern imprinted by the imprint template 40. The substrate may subsequently be chemically processed in a conventional manner.

As mentioned above, the evaporation of imprintable medium 45 from the imprint template 40 may be less than the evaporation that would have taken place if the imprintable medium had been provided on the substrate 42. This is due to the material properties of the imprint template 40.

Figure 5A shows schematically a droplet of imprintable medium 45a located on a substrate 46 which has a wetting surface. Unlike the substrate schematically shown in Figure 4, the substrate 46 schematically shown in Figure 5A has a conventional orientation. Figure 5B shows schematically a droplet of imprintable medium 45b located on a non-wetting surface 51.

In general, the interaction between a liquid and a solid surface will depend upon their respective polarities. If a liquid and a solid surface have the same polarity then the solid surface is a wetting surface. For example, a polar liquid, such as water, wets a polar glass substrate. In the case where the imprintable medium and a surface have the same polarity (the surface is wetting), for example when the surface is a substrate 46, the imprintable medium will spread more easily across the surface, and a droplet of the imprintable medium 45a will take the form schematically shown in Figure 5A. If the surface is non-wetting, for example if the liquid and the solid surface have opposite polarities, then the area of contact between the imprintable medium and the substrate is reduced. Where this is the case, a droplet of the imprintable medium 45b will take the form schematically shown in Figure 5B. A surface is usually defined as being wetting if the angle subtended between the surface and a liquid droplet (shown as θ in Figures 5A and 5B) is greater than 90 degrees. If the angle is less than 90 degrees, as schematically shown in Figure 5B, then the surface is generally referred to as being non-wetting.

The imprint template 40 is slightly wetting. This is illustrated in Figure 5C, in which a droplet of imprintable medium 45c subtends an angle with the imprint template surface 40 of slightly more than 90 degrees. The surface of the substrate 42 is significantly more wetting than the imprint template 40 (i.e. the angle θ is significantly greater than 90 degrees), as can be seen by comparing Figures 5A and 5C. For this reason, the droplet of imprintable medium 45c provided on the imprint template 40 has a smaller contact area with the imprint template than it would have had if it were provided on the substrate 46. Since the droplet of imprintable medium 45c has the same volume, the smaller contact area means that the height of the droplet is increased. The droplet 45c also has significantly less surface area; in other words the dome area of the droplet 45c is reduced as compared to the dome area of the droplet 45a provided on the substrate.

Evaporation takes place from the surface of the droplet of imprintable medium 45. The surface area of the droplet of imprintable medium 45c on the imprint template 40 is less than the surface area of the droplet of imprintable medium 45a on the substrate 46, due to the fact that the surface of the imprint template 40 is less wetting than that of the substrate 46. This means that evaporation of the imprintable medium 45 is reduced.

One contributing factor to the amount of evaporation of imprintable medium 45 may be heat transfer from the surface of the substrate 46 to the droplet of imprintable medium. The effect of heat transfer is reduced when the droplet of imprintable medium 45 is provided on the imprint template 40, since the droplet stands higher and has a smaller contact area with the surface, thereby reducing the amount of heat transfer. This assists in reducing the amount of evaporation of the imprintable medium.

The amount of evaporation which occurs at the edge of the droplet of imprintable medium 45 will in general be higher than for the rest of the droplet. Since the area of contact of the droplet of imprintable medium 45 provided on the imprint template 40 is less than that of the droplet provided on the substrate 46, the length of the edge of the droplet is reduced accordingly, and the amount of evaporation from the edge of the droplet is reduced.

A further advantage of the embodiment of the invention is that for a given volume of a droplet of imprintable medium 45, the critical distance between the droplets is reduced. The critical distance is the distance required in order to ensure that two droplets of imprintable medium 45 do not come into contact with one another and coalesce to form a single droplet. Since the critical distance is reduced, this allows more flexibility in the pattern of droplets of imprintable medium 45 that may be provided prior to imprint.

As previously mentioned, the imprint template 40 is provided with recesses which together form a pattern to be imprinted into the imprintable medium 45. The pattern in general will comprise structures of a resolution of nanometers or tens of nanometers. This structure has the effect of decreasing the angle subtended between each droplet of imprintable medium 45 and the imprint template 40, i.e. it makes the imprint template less wetting. This effect is sometimes referred to as the Lotus effect, and is seen in the leaves of the Lotus plant, the leaves being provided with tiny hairs which make them non-wetting and encourage droplets of water to roll along them picking up dirt and cleaning the leaves as they go.

At the time when the imprint template 40 is pressed against the substrate 42, the less-wetting property of the imprint template does not prevent the imprintable medium 45 from flowing fully over the template to allow recesses in the imprint template to be filled. The material of the template is sufficiently wetting to allow the imprintable medium 45 to flow into all of the recesses in the imprint template. An imprint template made from conventional material (for example, quartz) may be used together with a substrate made from a conventional material (for example, silicon). The imprint template 40 is located beneath the substrate 42 so that gravity acts to retain the droplets of imprintable medium 45 which are provided on the upper surface of the imprint template. If the imprint template 40 were to be located above the substrate 42 and were to be faced down, then gravity would tend to cause the droplets of imprintable medium 45 to fall from the imprint template.

As mentioned further herein, the substrate 42 may be provided with a planarization and transfer layer (not illustrated in Figures 4 and 5). The planarization and transfer layer acts to provide a surface substantially parallel to that of the imprint template 40. The planarization layer improves the aspect ratio of the imprinted features during etching of the features.

Although the imprint template 40 is schematically shown in Figures 4 and 5 as being horizontal, it will be appreciated that the imprint template may be at a slight angle to the horizontal, provided that the angle is not so large that it causes droplets of imprintable medium 45 to travel over the surface of the imprint template.

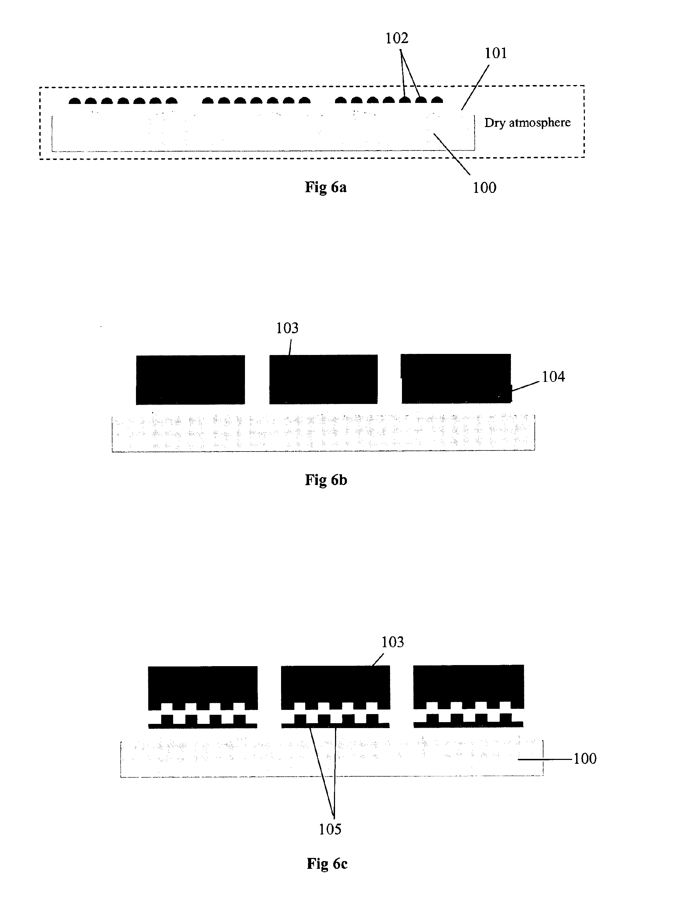

In an embodiment of the invention, a cyanoacrylate may be used to cure the imprintable medium instead of UV radiation. Referring to Figure 6a, a substrate 100 is provided with a planarization and transfer layer 101. A low viscous cyanoacrylate 102 is ink-printed as an array of droplets onto the substrate 100. This is done in a dry atmosphere since cyanoacrylates polymerize upon contact with water. The ink-printing of the cyanoacrylate 102 is fast, typically a few seconds being required to provide cyanoacrylate across the entire substrate 100. As schematically shown in Figure 6b, once the entire substrate 100 has been provided with cyanoacrylate 102, an imprint template 103 which has previously been provided with a layer of imprintable medium 104 is aligned with the substrate 100 and pressed onto the substrate. This causes polymerization of the cyanoacrylate 102 to occur, i.e. curing the imprintable medium. Once polymerization or curing of the imprintable medium 104 has been completed, the imprint template 103 is removed from the substrate 100 as schematically shown in Figure 6c. The cured imprintable medium 104 remains on the substrate 100, and includes a pattern which corresponds with a pattern on an underside of the imprint template 103.

The imprintable medium 104 may, for example, be a silicon rich polymer. A polymer of this type is advantageous because it is wetting, and thus easily passes into recesses 150 forming a pattern provided on the imprint template 103. This allows the imprint step itself, i.e. the pressing of the imprint template 103 onto the substrate 100, to be completed quickly. The pressure of the imprinting step can be selected so as to allow the imprint step to be performed without undue delay.

An advantage of this embodiment of the invention is that UV radiation (or other actinic radiation) is not required in order to cure the imprintable medium 104. This means that the imprint template 103 does not need to be fabricated from material which is transparent to UV radiation. A suitable inexpensive material may be used to fabricate the imprint template, for example nickel or other metals.

It is noted that the cyanoacrylate 102 does not contain silicon and therefore will not form an etch barrier. Instead, the cyanoacrylate 102 may be considered to be an extension of a planarization layer 101 provided on the substrate 100. In other words, the amount of etching needed in order to ensure that features of the pattern imprinted in the imprintable medium 104 are properly defined is not affected by the cyanoacrylate.

Examples of cyanoacrylates that may be used for this embodiment of the invention include methyl- cyanoacrylate, ethyl-cyanoacrylate, or alkoxy-ethyl-cyanoacrylate. Cyanoacrylates are sometimes referred as superglue. The structural formula of ethyl-cyanoacrylate is shown for example below.

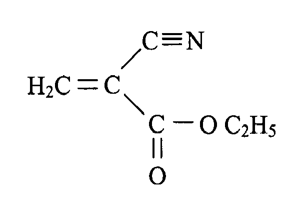

Cyanoacrylates usually have a low viscosity (typically 1-10 cps), and can adhere two parts together in a few seconds (typically 3-20 seconds).

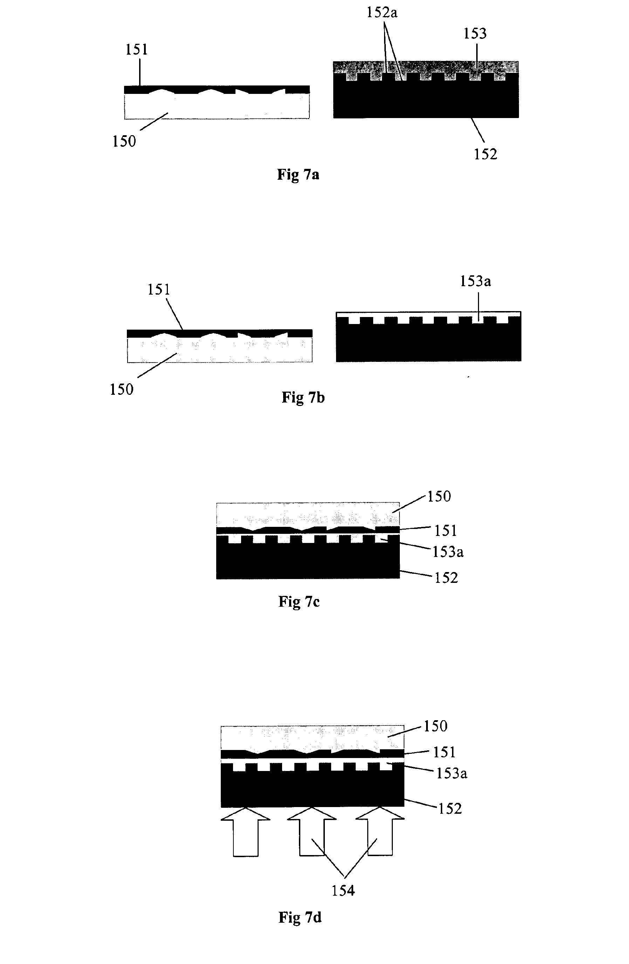

An alternative or additional embodiment of the invention is schematically shown in Figure 7. Referring to Figure 7a, a substrate 150 is spin coated with a layer of monomer 151. An imprint template 152 is provided with a layer of polymer and solvent 153. The polymer, which contains silicon, is dissolved in the solvent. The polymer and solvent 153 may be spin coated onto the imprint template 152. In one arrangement, which is described further below, the imprint template 152 may be one of a set of imprint templates which are, for example, provided together with an imprint set holder, such that the polymer and solvent 153 may be spin coated onto the set of imprint templates and the imprint template set holder.

The imprint template 152 is provided with a patterned uppermost surface 152a. The patterned uppermost surface 152a is covered with a release layer comprising, for example, a self assembled layer of fluorinated alkyl trichlorosilane or fluorinated alkyl alkoxysilane.

Referring to Figure 7b, the solvent evaporates quickly, during spin coating, from the layer of polymer and solvent 153 so that a layer of solid polymer 153a is formed. The evaporation may take, for example, around 10 seconds.

Referring to Figure 7c, the substrate 150 is inverted and positioned on top of the imprint template 152, such that the layer of monomer 151 comes into contact with the layer of polymer 153a.

Referring to Figure 7d, ultraviolet radiation 154 is directed through the imprint template 152, and is thereby incident upon the polymer layer 153a and the layer of monomer 151. The imprint template 152 may, for example, be made from quartz, which is transmissive to ultraviolet radiation. The layer of polymer 153a is also transmissive to ultraviolet radiation (or is at least partially so). This ensures that a substantial amount of ultraviolet radiation is incident upon the monomer layer 151. The monomer layer 151 is polymerized by the ultraviolet radiation, and thereby acts as a glue which adheres to the substrate 150 and to the layer of polymer 153a. The layer of polymer 153a is thereby fixed to the substrate 150.

The substrate 150 is moved upwards (and/or the imprint template 152 is lowered) so that the substrate 150 and imprint template 152 are separated (this is not shown in Figure 7). The layer of polymer 153a, which is fixed to the substrate, is released from the imprint template 152. The layer of polymer 153a retains a pattern which corresponds with the patterned uppermost surface 152a of the imprint template 152. Release of the polymer layer 153a from the imprint template 152 is facilitated by the release layer provided on the imprint template 152.

Although the above description refers to a layer of monomer 151, it will be appreciated that a blend of monomer and polymer may instead be used.

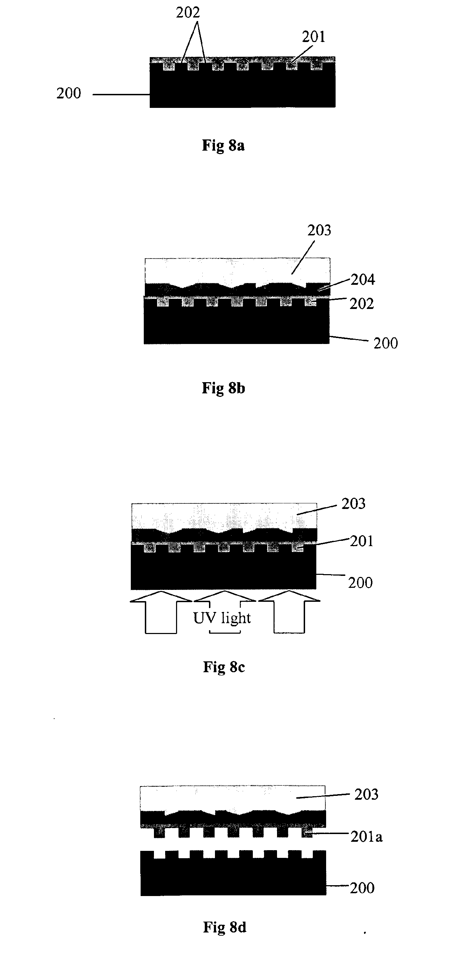

An alternative or additional embodiment of the invention is schematically shown in Figure 8. Referring to Figure 8a, an imprint template 200 is provided with a mixture of silicon rich monomer and silicon rich polymer 201, which may be in the form of a liquid or a gel. The polymer/monomer mixture 201 may be applied to the imprint template 200 via spin coating. As will be described further below, the imprint template 200 may be one of a set of imprint templates which are arranged in an array, together with an imprint template set holder. Where this is the case, the spin coating of the polymer/monomer mixture may be across the array of imprint templates.

The viscosity of the polymer/monomer mixture 201 is sufficiently high that it avoids break up during spin coating. The viscosity of the polymer/monomer mixture increases during spin coating due to monomer evaporation.

The polymer/monomer mixture 201 is arranged such that the amount of the mixture which extends above an uppermost surface of the imprint template 200 is thin. This amount is referred to as the residual layer 202. A thin and substantially homogenous residual layer 202 is desired since it allows a lesser amount of etching to be undertaken following completion of the imprint process.

Referring to Figure 8b, a substrate 203 is provided with a planarization layer 204. The substrate 203 is inverted and is brought into contact with the polymer/monomer mixture 202. Alignment of the imprint template 200 with respect to the substrate 203 may take place in order to ensure that the imprint template 200 is at a desired location with respect to the substrate. The alignment may be performed using, for example, conventional alignment optics. Alignment may take place after contact has occurred between the planarization layer 204 and the polymer/monomer mixture 201, or may alternatively take place before the contact.

The substrate 203 and imprint template 200 are pressed together to ensure that a good contact is made between the planarization layer 204 and the polymer/monomer mixture 201. Following this, as schematically shown in Figure 8c, ultraviolet radiation is directed through the imprint template 200, and passes into the polymer/monomer mixture 201. This causes the polymer/monomer mixture 201 to be cured, thereby converting it to a solid form. The substrate 203 is then separated from the imprint template 200, as schematically shown in Figure 8d. The polymer/monomer mixture, which has now been cured, is a solid 201 a, retains a pattern which corresponds to a pattern provided on the imprint template 200, and adheres to the planarization layer 204.

The amount of ultraviolet radiation which is required in order to cure the polymer/monomer mixture, instead of a conventionally used monomer, may be significantly reduced. This means that the imprint process may be completed more quickly, thereby improving the throughput of the imprint process.

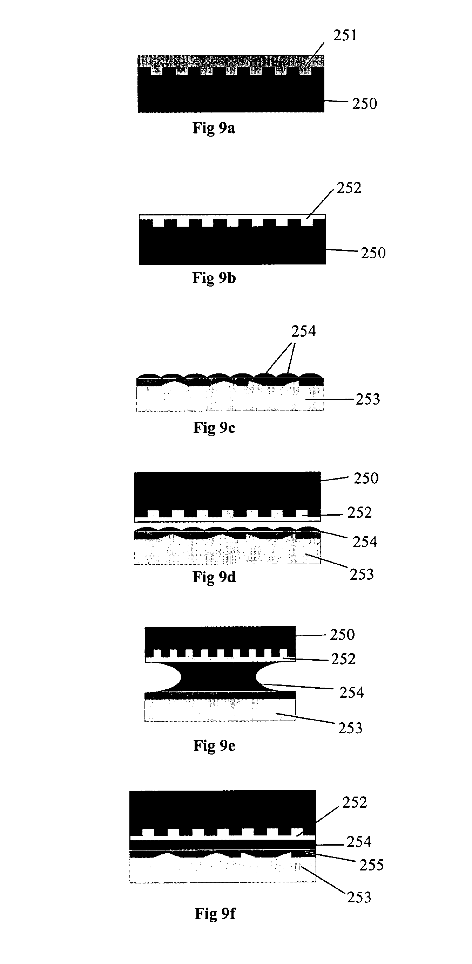

An alternative or additional embodiment of the invention is schematically shown in Figure 9. As schematically shown in Figure 9a, an imprint template 250 is provided with a layer of silicon rich polymer and solvent mixture 251. Due to evaporation, a polymer layer 252 is formed on the template 250, the polymer layer being substantially solid. As schematically shown in Figure 9b, a substrate 253 is provided with an array of droplets of a UV curable monomer 254.

Referring to Figure 9d, the imprint template 250 is inverted and moved towards the substrate 253 (and/or the substrate 253 is moved towards the imprint template 250), such that the layer of polymer 252 contacts with the droplets of monomer 254. The situation following contact is shown schematically, up close, in Figure 9e, wherein it can be seen that an angle of contact between the monomer 254 and the substrate 253 is small, and similarly an angle of contact between the monomer 254 and the layer of polymer 252 is also small (the angle of contact is the angle subtended between the monomer and the surface which it contacts). This small angle of contact is advantageous because it allows the monomer 254 to flow quickly.

In conventional prior art imprint lithography, the separation between the substrate and the imprint template during imprint must usually be less than 150 nanometers. The use of the liquid monomer 254 and the polymer layer 252 allows the effective separation between the substrate and the imprint template to be greater than 150 nanometers. This is because the monomer 254 does not contain silicon, and therefore will not form an etch barrier. Instead, the monomer 254 may be considered to be an extension of a planarization layer 255 provided on the substrate 253.

The time taken for an imprintable medium to spread fully across an imprint template is inversely proportional to the square of the final thickness of the layer of imprintable medium between the imprint template 250 and the substrate 253. Therefore, increasing the thickness of the layer of fluid (i.e. in this case the monomer 254) to 300 nanometers from a conventional thickness of 150 nanometers, provides a factor of 4 reduction of the time taken for the fluid to spread.

An additional or alternative advantage of the embodiment of the invention illustrated in Figure 9 is that spreading of the monomer 254 is faster than would be the case in the absence of the polymer 252, because the recesses of the imprint template are already filled by the polymer 252. This means that the monomer 254 spreads between two flat planes (this is easier than spreading between a flat plane and a plane provided with a pattern of recesses).

Referring to Figure 9f, once the monomer 254 has spread fully between the layer of polymer 252 and the substrate 253, UV radiation is passed through the imprint template 250. The UV radiation cures the monomer 254, thereby gluing the layer of polymer 252 to the substrate 253. The imprint template 250 is then raised (and/or the substrate 253 is lowered), leaving behind the patterned layer of polymer 252, which is glued by the monomer 254 to the substrate 253 (via the planarization layer 255).

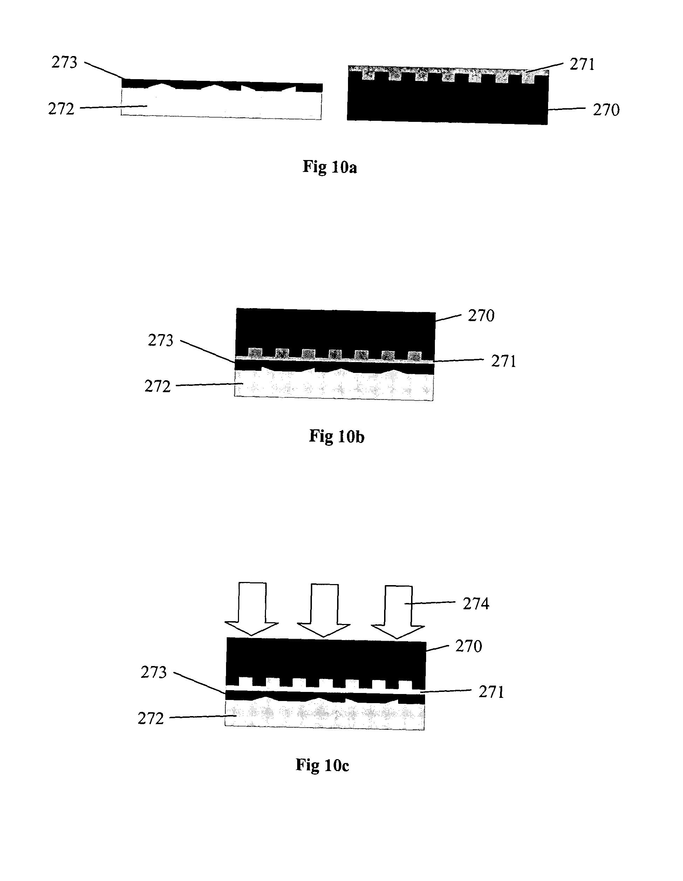

An alternative or additional embodiment of the invention is illustrated in Figure 10. As schematically shown in Figure 10a, an imprint template 270 is provided with a layer of silicon containing monomer of low viscosity. In some instances the layer may comprise a blend of silicon containing monomer and a polymer which may also be silicon containing. For ease of reference this layer will hereafter be referred to as the monomer layer 271. The viscosity of the monomer layer is sufficiently low that all pattern features included on the imprint template 270 are filled by the monomer.

A substrate 272 is provided with a planarization layer 273. The planarization layer 273 comprises a monomer or a blend of a monomer and a polymer (neither of which contains silicon), and is a low viscosity fluid. The planarization layer 273 is sufficiently thick that it covers the entire surface of the substrate 272, i.e. there are no locations at which the substrate projects through the planarization layer.

The imprint template 270 is inverted and positioned above the substrate 272. The imprint template is then moved downwards (and/or the substrate is moved upwards) so that the monomer layer 271 comes into contact with the planarization layer 273, as schematically shown in Figure 10b. Both the monomer layer 271 and planarization layer 273 are fluids when the contact takes place. UV radiation 274 is used to illuminate the monomer layer and the planarization layer, as schematically shown in Figure 10c, and polymerizes both layers such that they become solid. The imprint template 270 is then moved upwards (and/or the substrate 272 is moved downwards) so that the imprint template 270 and substrate 272 are separated. A release layer provided on the imprint template 270 helps to ensure that the imprint template releases properly from the now polymerized layer 271 (this was formerly the monomer layer 271).

Because the planarization layer 273 is fluid when the contact is made between the planarization layer and the monomer layer 271, the risk of damage to the substrate 272 or the imprint template 270 during imprint is reduced. This allows a reduction of the thickness of the monomer layer 271, and in particular of the so-called residual layer (this is the thickness of the monomer layer which extends above the top of the patterned surface of the imprint template 270).

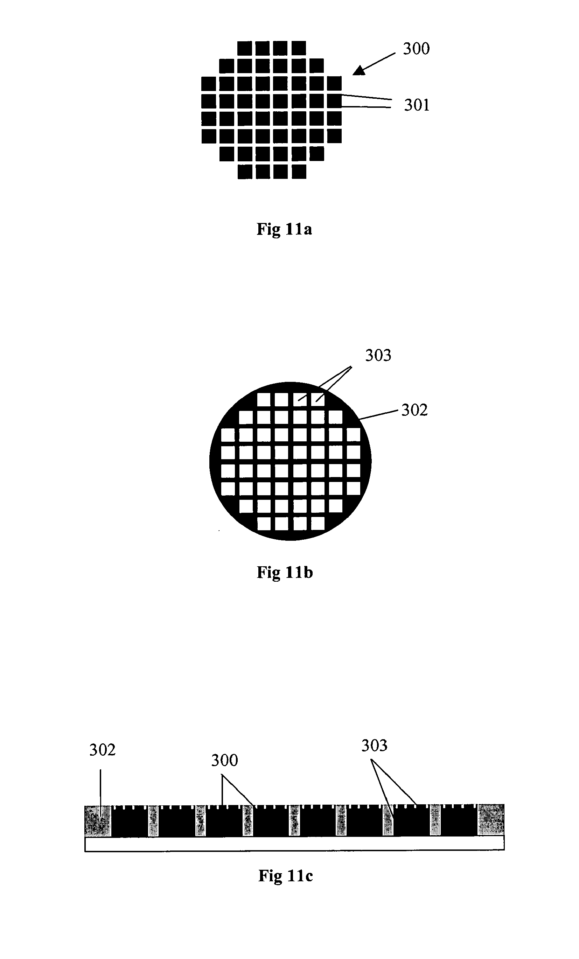

An alternative embodiment or additional of the invention is illustrated in Figure 11. Referring to Figure 11 a, an array of, for example, fifty two imprint templates 300 is arranged in a configuration which corresponds roughly to the useful area of a conventional 300mm silicon wafer. Each of the imprint templates is separated by a channel 301.

A template set holder 302 is schematically shown in Figure 11b. The template set holder 302 is circular (although may have other shapes) and has an outer perimeter which corresponds approximately with the outer perimeter of a conventional 300mm substrate. The template set holder 302 is provided with fifty two openings 303, each of which is dimensioned to receive an imprint template 300.

Figure 11c is a cross sectional schematic view of a template set holder 302 provided with imprint templates 300. It can be seen that the openings 303 provided in the template set holder 302 have a depth which is arranged such that when the imprint templates 300 are held therein, an uppermost surface of the imprint templates 300 is flush with an uppermost surface of the template set holder 302 (the term 'uppermost surface of the template set holder' is intended to refer to that portion of the template set holder which in use is located over or under a substrate, and is not intended to include peripheral parts of the imprint template holder).

By providing the imprint templates 300 and the template set holder 302 as schematically shown in Figure 4, spin coating of an imprintable medium (or other suitable medium) across a plurality of templates may be easily achieved by spinning the template set holder 302. The fact that the uppermost surface of the imprint templates 300 and the surfaces of template set holder 302 are flush allows the imprintable medium to travel more easily across the template set holder and imprint templates.

Although the above embodiments of the invention have been described in terms of a conventional 300mm diameter wafer, it would be appreciated that the embodiment of the invention may be applied to any other suitable substrate. For example, the template set holder 302 may be dimensioned so as to correspond with a conventional 200mm diameter wafer. It will be appreciated that any number of imprint templates, and corresponding openings, may be used. This may vary, for example, depending upon the size and shape of the templates and size and shape of the substrate.

Various arrangements in which a template set holder and imprint templates corresponding to the embodiment of the invention may be used, are described below.

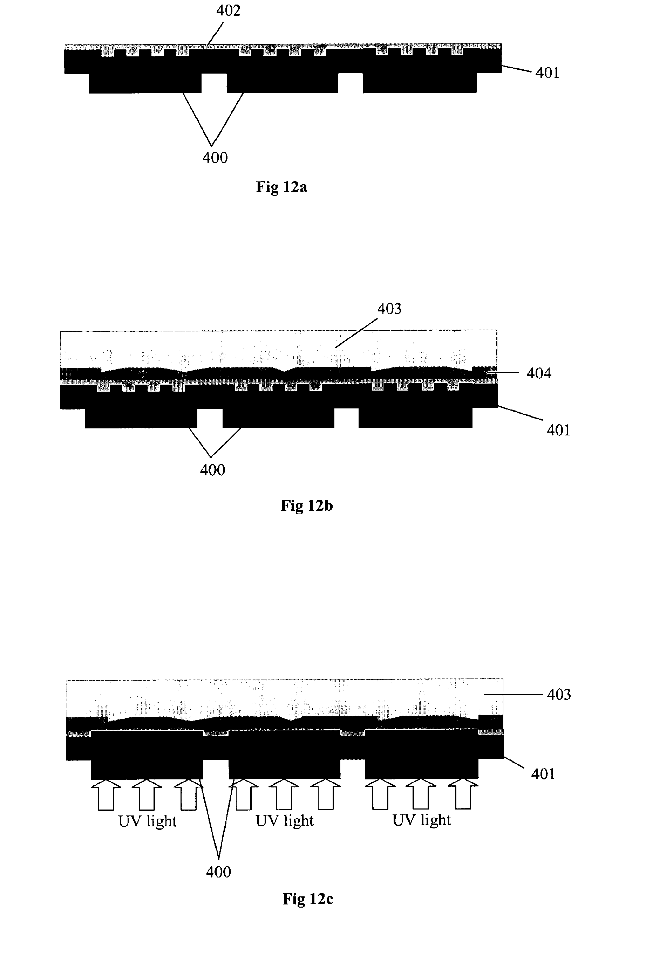

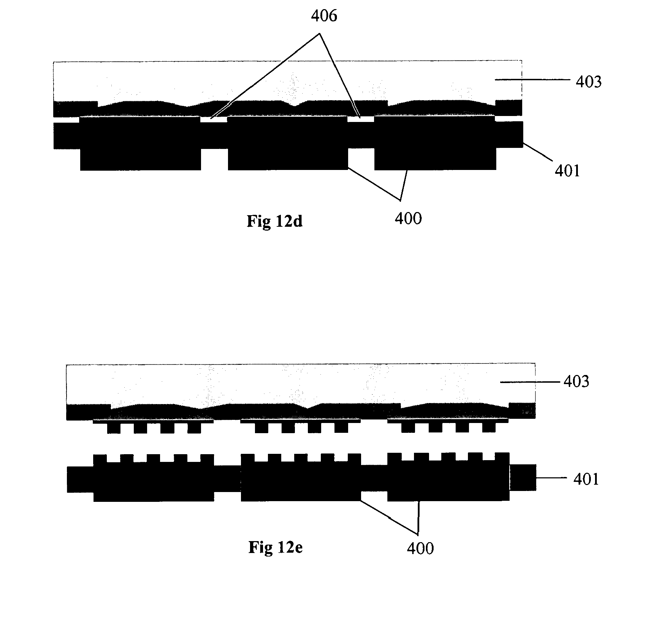

An alternative or additional embodiment of the invention is schematically shown in Figure 12. A plurality of imprint templates 400 are held in a template set holder 401. Although only three imprint templates are schematically shown in Figure 12a, this is for ease of illustration and it will be appreciated that sufficient imprint templates may be provided such that they cover an entire substrate (for example, a silicon wafer). The imprint templates 400 and template set holder 401 are covered with a liquid layer of silicon rich monomer 402. This may be done using spin coating.

A substrate 403 is provided with a planarization layer 404. The substrate is then inverted and located over the imprint templates 400 and the template set holder 401. The substrate 403 is then moved downwards (and/or the imprint templates 400 are moved upwards) until the planarization layer 404 presses onto the layer of silicon rich monomer 402 provided on the imprint templates 400 and the template set holder 401. Care is taken to avoid the inclusion of gas pockets or bubbles when the planarization layer 404 comes into contact with the silicon rich monomer 402.

Alignment of the substrate 403 with the imprint templates 400 takes place after contact has occurred between the planarization layer 404 and the silicon rich monomer 402. Alignment may be performed, for example, by using optical alignment apparatus arranged to view alignment marks (not shown) provided on the substrate 403. The template set holder 401 may be formed from a deformable material, such that the position of a given imprint template 400 relative to its neighbors may be adjusted, without removing the imprint template from the template set holder 401. Once alignment of the imprint templates 400 to the substrate 403 has been achieved, the substrate 403 is pressed downwards onto the imprint templates 400 (and/or vice versa), such that the liquid silicon rich monomer 402 adheres to the planarization layer 404.

Once sufficient time has been allowed to elapse for the silicon rich monomer 402 to adhere to the planarization layer 404, UV radiation is used to cure the silicon rich monomer 402. The imprint templates 400 are formed from material which is transparent to UV radiation, whereas the template set holder 401 is formed from a material which is opaque to ultraviolet radiation. This means that the UV radiation passes only through the imprint templates 400, with the result that only the silicon rich monomer 402 which is located above imprint templates 400 is illuminated, and cured, by the ultraviolet radiation. The silicon rich monomer 402 is polymerized by the ultraviolet radiation, thereby forming a solid which is resistant to etching chemicals.

The silicon rich monomer 402 which is located above the template set holder 401 remains in a monomer form, i.e. it is not polymerized.

Suitable materials which may be used to form the imprint templates 400 include quartz or plastic. Suitable materials which may be used to form the template set holder 401 include plastic coated steel or a plastic with a strong UV absorber. If a deformable template set holder 401 is desired, then plastic coated with a strong UV absorber or other suitable deformable material may be used.

The areas of silicon rich monomer 402 which has not been polymerized are removed via evaporation, with the imprint templates 400 remaining in position, as schematically shown in Figure 12d. This is achieved by applying a low pressure to the environment in which the imprint templates 400 and the substrate 403 are located. The low pressure causes evaporation of the non-polymerized monomer to occur rapidly, while the polymerized silicon rich monomer 402 is unaffected. The result of the evaporation is channels 406 which run between the imprint templates 400. The channels form a grid, which passes between each of the imprint templates 400.

The monomer gas which is evaporated comprises silicon rich monomer. This gas may be collected and disposed of.

Referring to Figure 12e, once evaporation has been completed, the imprint templates 400 are moved downwards and away from the substrate 403 (and/or vice versa). The substrate 403 may then be removed to allow for subsequent chemical processing, for example etching. The imprint templates 400 and the template set holder 401 are then provided with a new layer of silicon rich monomer, and the process schematically shown in Figures 12a to 12e is repeated.

The removal of the imprint templates 400 from the substrate 403 may take place individually, i.e. with each imprint template 400 separately being removed from the substrate. This is possible because of the evaporation of monomer between the imprint templates 400, together with the deformable nature of the templates set holder 401, allows any given imprint template 400 to be moved away from the substrate without adversely affecting (for example, causing unwanted movement of) its neighbors. In an alternative arrangement, all of the imprint templates 400 may be removed from the substrate 403 in a single operation. In a further alternative arrangement, specific subsets, for example rows, of imprint templates 400 may be removed from the substrate 403 in separate operations. An advantage of the removal of the silicon rich monomer 402 from between the imprint templates 400 is that the force required in order to remove the imprint templates 400 from the substrate 403 (and/or vice versa) is reduced. In addition, the risk of damaging features on the imprint templates 400 and/or the substrate 403 is reduced.

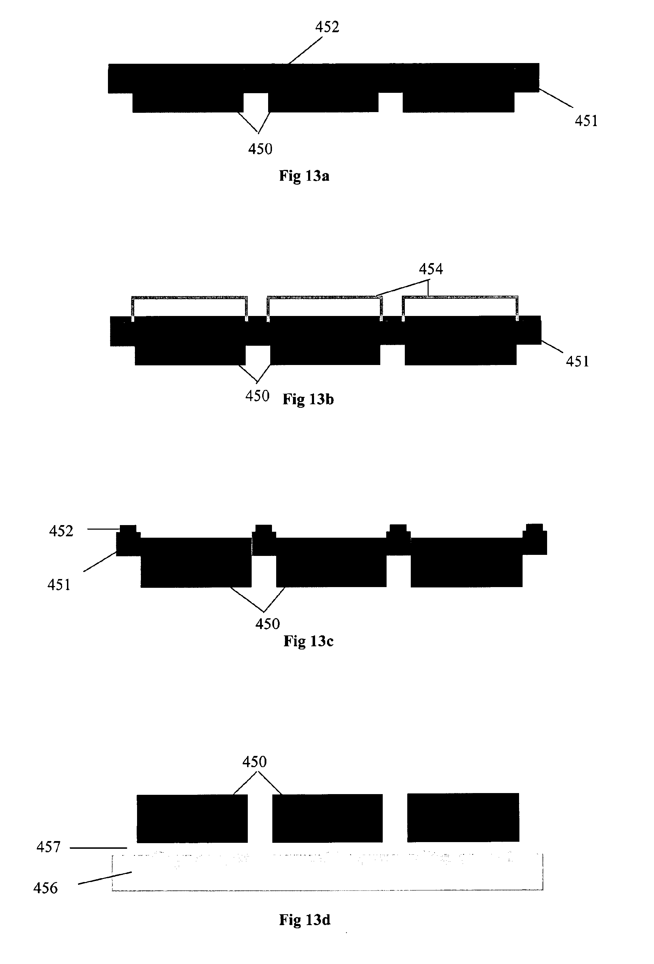

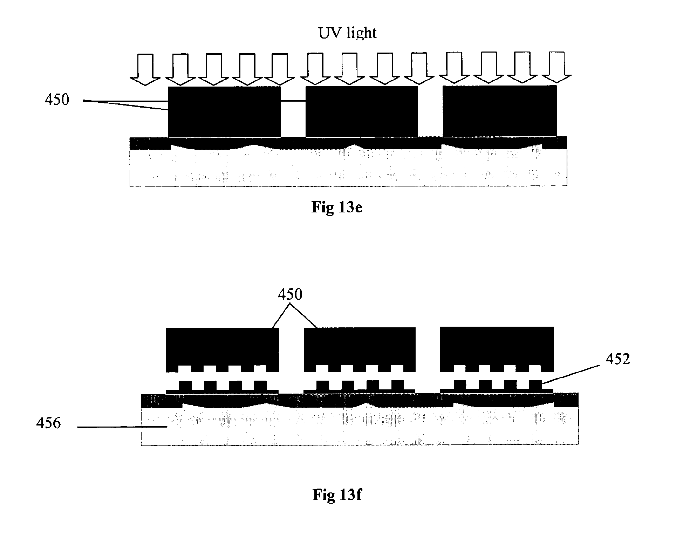

An alternative or additional embodiment of the invention is illustrated schematically in Figure 13. Figure 13a shows a set of imprint templates 450 held in a template set holder 451. A layer of silicon rich polymer 452 is spin coated from solution onto the imprint templates 450 and template set holder 451 to form a solid layer.

Figure 13b shows schematically a set of punches 454, each of which is provided with an inner periphery which is slightly larger than the imprint templates 450. The set of punches 454 are moved downwards (and/or the imprint templates 400 are moved upwards) such that they cut into the layer of silicon rich polymer 452. The punches 454 move through the layer of silicon rich polymer 452 until they press upon the template set holder 451. Once this has been done, the set of punches 454 are separated from the silicon rich polymer 452. The action of the punch is to cut around the periphery of the silicon rich polymer 452 on a given imprint template 450, so that the silicon rich polymer which is on the imprint template is detached from the silicon rich polymer which surrounds it.

A separation is provided between the punches 454, to allow silicon rich polymer 452 which is provided on the template set holder 451, rather than the imprint templates 450, to remain.

The set of punches 454 do not need to have high precision, for example on a nanometer scale. All that is required is that silicon rich polymer 452 provided on the imprint templates 450 is not cut by the set of punches 454, and that only a small amount of silicon rich polymer remains beyond the edges of the imprint templates 450.

Referring to Figure 13c, the template set holder 451 is moved upwards and away from the imprint templates 450 (or vice versa). The template set holder 451 carries with it that portion of silicon rich polymer 452 which is provided on its upper surface. The silicon rich polymer 452 may be removed and reused for a subsequent substrate.

It can be seen from Figure 13c that the precision of the cutting provided by the set of punches 454 should be sufficiently good that a substantial amount of silicon rich polymer 452 does not extend beyond the edge of the imprint template 450 and onto the template set holder 451. This is the reason why a simplified set of punches which cut along centre lines between imprint templates 450 is not used. If such a substantial amount of silicon rich polymer 452 were to extend over the template set holder in this manner, then when the template set holder is moved upwards (and/or the imprint templates 450 moved downwards) it might be caused to fold over and back onto the template 450 itself, thereby providing a dual layer of silicon rich polymer 452 in that region. This is to be avoided because it would result in a poor contact between the silicon rich polymer 452 and the planarization layer during the steps described below. This might lead to the inclusion of gas pockets between the silicon rich polymer and the planarization layer and/or might result in a non-uniform etch barrier being formed.

Referring to Figure 13d, once the template set holder 451 has been removed the imprint templates 450 are inverted,. A substrate 456 provided with a planarization layer 457 is brought into contact with the silicon rich polymer layer 452 provided on the imprint templates 450. The planarization layer 457 may comprise a monomer solution, or may be a monomer/polymer mixture. The solution or mixture is spin coated onto the substrate 456.

The imprint templates 450 may be aligned with the substrate 456. This may be achieved by using an alignment apparatus to determine the location of, for example, alignment marks provided on the substrate 456, and adjusting the position of one or more of the imprint templates 450. The position of the imprint template(s) 450 may be controlled by, for example, stepper motors or other position controlling apparatus. Alignment may be performed before the planarization layer 457 comes into contact with the silicon rich polymer layer 452. Alternatively or additionally, alignment may take place shortly after the contact has occurred.

Following contact between the planarization layer 457 and the silicon rich polymer 452, the substrate 456 is pushed upwards towards the imprint templates 450 (or the imprint templates 450 are moved downwards to the substrate 456) to ensure that a good contact is formed between the planarization layer and the silicon rich polymer.

Referring to Figure 13e, UV radiation is directed at the imprint templates 450, and passes through the imprint templates thereby being incident upon the silicon rich polymer 452 and the planarization layer 457. The UV radiation causes the planarization layer 457 to polymerize. This converts the planarization layer 457 into a solid form, bonding the silicon rich polymer 452 to the planarization layer. The imprint templates 450 may be constructed from quartz, plastic, or any other suitable material which is substantially transparent to UV radiation.

Referring to Figure 13f, the imprint templates 450 are moved upwards and away from the substrate 456 (or vice versa), leaving behind regions of silicon rich polymer 452 which are provided with an imprinted pattern. The imprint templates 450 may be provided with a release layer (a layer of material which allows easy separation of the silicon rich polymer therefrom) to assist in the removal of the imprint templates from the silicon rich polymer 452. The release layer may help to ensure that the pattern provided in the layer of silicon polymer 452 is not damaged, for example, by unwanted adhesion when the imprint templates 450 are separated from the substrate.

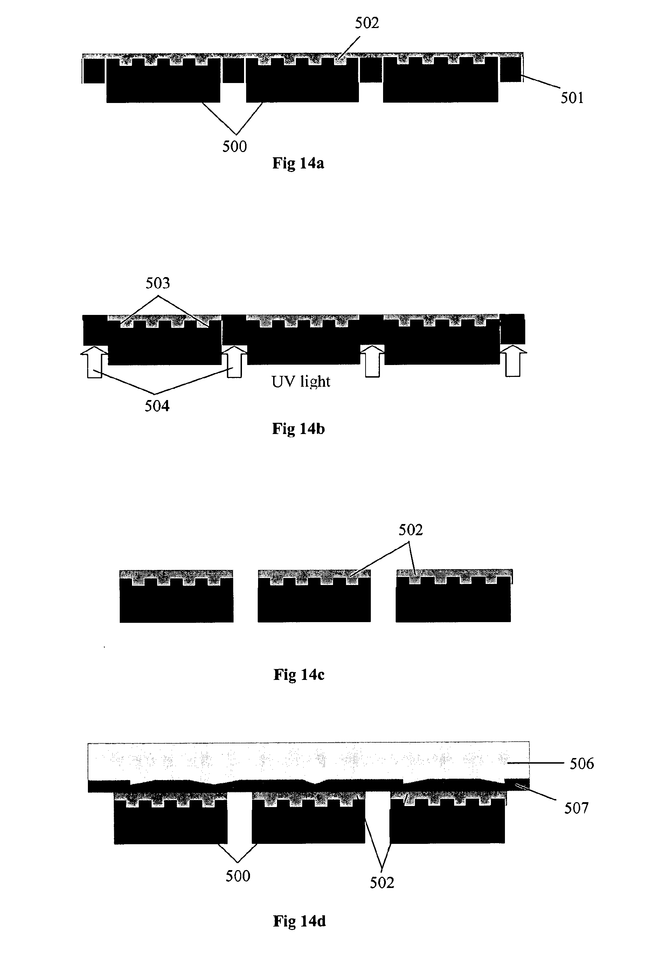

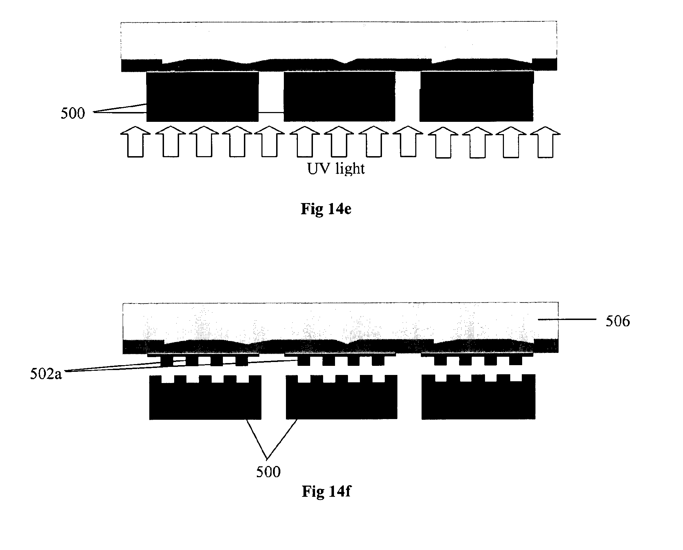

An alternative or additional embodiment of the invention is shown schematically in Figure 14. Referring to Figure 14a, a set of imprint templates 500 is held by a template set holder 501. A layer of silicon rich monomer 502 is spin coated onto the imprint templates 500 and template set holder 501. The template set holder 501 is fabricated from a material which is substantially transparent to UV radiation, for example quartz or a suitable plastic. Similarly, the imprint templates 500 are substantially transparent to UV radiation and may be fabricated from, for example, quartz or a suitable plastic. Side walls of the imprint templates 500 and/or of the template set holder 501 adjacent the imprint templates 500 are provided with a layer of material which is opaque to UV radiation, thereby acting as an UV radiation barrier. The layer of material may, for example, comprise a strongly UV radiation absorbing polymer layer.

Referring to Figure 14b, UV radiation (as depicted by arrows 504) is directed through the template set holder 501, but does not pass through the imprint templates 500. This may be achieved, for example, by providing radiation guiding apparatus which guides the UV radiation to the template set holder, and ensuring that sides of the template set holder and/or the imprint templates are opaque to UV radiation. The radiation guiding apparatus may, for example, comprise optical fibers or suitable radiation guiding channels.

The UV radiation polymerizes the areas of silicon rich monomer 502 which are located on the template set holder 501. This is indicated schematically by a darkening of the silicon rich monomer in those regions. This forms a grid of silicon rich polymer which is a solid (the silicon rich monomer 502 is a fluid or gel). Following this polymerization, the template set holder 501 is moved downwards and away from the imprint templates 500 (and/or the imprint templates 500 are moved upwards and away template set holder 501) removing with the template set holder the regions of silicon rich polymer located thereon. What is left behind is a set of imprint templates 500 each of which is provided with a layer of silicon rich monomer 502.

Referring to Figure 14d, a substrate 506 is spin coated with a planarization layer 507. The planarization layer may, for example, comprise a polymer mixture. The substrate 506 is inverted once it has been provided with the planarization layer 507, and is brought into contact with the silicon rich monomer 502 provided on the imprint templates 500.

If desired, each of the imprint templates 500 may be aligned with a particular location on the substrate 506. This may be achieved by using an alignment apparatus (which may be optical) arranged to monitor the position of alignment marks provided on a substrate. The positions of the imprint templates 500 may be adjusted based upon the determined locations of the alignment marks, for example using a stepper motor or other suitable adjustment means. The alignment may take place prior to contact occurring between the planarization layer 507 and the layer of silicon rich monomer 502. Alternatively or additionally, the alignment may take place shortly after the contact has occurred.

Once contact has occurred between the planarization layer 507 and the silicon rich monomer 502, the substrate 506 is pushed downwards (and/or the imprint templates 500 are moved upwards) to ensure that a good contact is made between the planarization layer 507 and the layer of silicon rich monomer 502.

Referring to Figure 14e, UV radiation is directed at the imprint templates 500. The ultraviolet radiation passes through the imprint templates 500 and is incident upon the silicon rich monomer 502 and the planarization layer 507. The ultraviolet radiation acts to cure the silicon rich monomer 502 such that it polymerizes to form a silicon rich polymer 502a.

Following illumination by the UV radiation, the substrate 506 is moved upwards and away from the imprint templates 500 (or vice versa). The silicon rich polymer 502a adheres to the planarization layer 507 and bears a pattern which has been transferred from the imprint templates 500. The imprint templates 500 may be provided with a release layer which facilitates easy release of the imprint templates 500 from the silicon rich polymer 502a.

While specific examples of the invention have been described above, it will be appreciated that the present invention may be practiced otherwise than as described. The description is not intended to limit the invention.

The substrate 100 may be held in a substrate holder, and similarly the imprint template 103 may be held in a template holder.

The use of a release layer has only been described in relation to some of the above embodiments of the invention. However, it will be appreciated that a release layer may be applied in other embodiments of the invention.

Alignment of the template with respect to the substrate has only been described in relation to some of the above embodiments of the invention. However, it will be appreciated that such alignment may be used in other embodiments of the invention.

There are references at various points in the above descriptions of embodiments of the invention to the substrate being moveable towards and away from the imprint template, or the imprint template being moveable towards and away from the substrate. It will be appreciated that, where suitable, either or both of these alternatives may be used for the embodiments of the invention. Furthermore, both the substrate and the imprint template may be moveable.

It will be appreciated by those skilled in the art that UV radiation is given as an example of actinic radiation in the above described embodiments of the invention, and that other suitable wavelengths of electromagnetic radiation may be used.

A photo-initiator which absorbs actinic radiation may be included in the monomer liquid or polymer monomer mixture. This speeds up the absorption of the actinic radiation and thereby speeds up the polymerization process.

In some instances a proportion of polymer may be added to the monomer. This may be done, for example, to change fluid properties of the monomer and/or to reduce the amount of time needed for polymerization of the monomer. Thus, the term monomer should not necessarily be interpreted as meaning that no polymer is present, but may instead be interpreted as meaning that some polymer may be present.

Although some of the embodiments of the invention have been described in terms of a single imprint template, it will be appreciated that the single imprint template may be one of a set of imprint templates. In general, the skilled person will appreciate that different embodiments of the invention, and one or more features thereof, may be combined together.

## Claims

1. A lithographic apparatus comprising a template holder configured to hold a plurality of imprint templates and a substrate holder configured to hold a substrate, wherein the template holder is located beneath the substrate holder.

2. The apparatus according to claim 1, further comprising a plurality of imprint templates held in the template holder, the imprint templates having a patterned upper surface.

3. The apparatus according to claim 1 or claim 2, further comprising one or more ink jet nozzles arranged to direct imprintable medium onto the imprint templates.

4. A lithographic apparatus comprising a template holder configured to hold a plurality of imprint templates and a substrate holder configured to hold a substrate, wherein the template holder is arranged such that when the imprint templates are held in the template holder an upper surface of the imprint templates remains exposed.

5. The apparatus according to claim 4, further comprising a plurality of imprint templates held in the template holder, the imprint templates having an exposed upper surface provided with a pattern.

6. The apparatus according to claim 4 or claim 5, further comprising one or more ink jet nozzles arranged to direct imprintable medium onto the imprint templates.

7. A lithographic apparatus comprising a template holder configured to hold a plurality of imprint templates and one or more dispensers arranged to dispense a fluid onto the plurality of imprint templates.

8. The apparatus according to claim 7, wherein the one or more dispensers are ink jet nozzles.

9. The apparatus according to claim 7 or claim 8, wherein the fluid is an imprintable medium.

10. The apparatus according to any of claims 7 to 9, further comprising a substrate table configured to hold a substrate.

11. A method of imprint lithography comprising applying an imprintable medium to patterned surfaces of a plurality of imprint templates and then contacting the imprint templates against a substrate, such that the imprintable medium is transferred to the substrate.

12. The method according to claim 11, further comprising illuminating the transferred imprintable medium with actinic radiation of a wavelength suitable to cure the imprintable medium.

13. The method according to claim 11 or claim 12, further comprising applying a planarization layer to the substrate prior to contacting the imprint templates against the substrate.

14. A lithographic apparatus comprising a template holder configured to hold a plurality of imprint templates, the template holder being arranged such that uppermost surfaces of the imprint templates, when held in the template holder, lie substantially in the same plane.

15. The apparatus according to claim 14, wherein the imprint template holder is arranged such that an uppermost surface of the imprint templates, when held in the template holder, lies in substantially the same plane as an uppermost surface of the imprint template holder.

16. A lithographic apparatus, comprising:
a template holder configured to hold a plurality of imprint templates;
a substrate holder configured to hold a substrate; and
a plurality of punches which are associated with respective imprint templates, wherein each punch is dimensioned such that it would punch around an area which is larger than the area of the imprint template with which it is associated.

17. The apparatus according to claim 16, wherein gaps are provided between the punches such that regions would remain between imprint templates, which do not fall within the punches.

18. A method of imprint lithography, comprising:
applying an imprintable medium to patterned surfaces of a plurality of imprint templates and to an imprint template holder which holds the plurality of imprint templates;
allowing the imprintable medium to become substantially solid;
using punches to cut through the substantially solid imprintable medium, the punches being arranged to cut through the imprintable medium along a periphery which falls outside of the periphery of each imprint template; and
contacting the imprint templates against a substrate.

19. The method according to claim 18, further comprising removing imprintable medium from between imprint templates following cutting by the punches.

20. The method according to claim 18 or claim 19, further comprising providing a planarization layer on the substrate, such that the imprintable medium comes into contact with the planarization layer when the imprint templates come into contact with the substrate.

21. The method according to claim 20, wherein the planarization layer is fluid when the imprintable medium is brought into contact with it, and is subsequently cured.

22. A lithographic apparatus, comprising:
a template holder configured to hold a plurality of imprint templates;
a substrate holder configured to hold a substrate;
a source of actinic radiation; and
a radiation guiding apparatus arranged to direct the actinic radiation through the template holder without directing the actinic radiation through the imprint templates.

23. A method of imprint lithography, comprising:
applying an imprintable medium to a patterned surface of an imprint template;
applying a cyanoacrylate to a surface of a substrate; and
contacting the imprint template against the substrate, such that the cyanoacrylate induces polymerization of the imprintable medium.

24. The method according to claim 23, wherein the cyanoacrylate does not contain silicon and does not form an etch barrier.

25. A method of imprint lithography, comprising:
applying a polymer and a solvent to a patterned surface of an imprint template;
allowing the solvent to evaporate such that the polymer becomes solid;
applying a layer of monomer to a substrate;
contacting the imprint template against the substrate such that the polymer is pushed against the monomer layer; and
after contacting, illuminating the monomer layer with actinic radiation.

26. The method according to claim 25, wherein the layer of monomer includes a proportion of polymer.

27. A method of imprint lithography, comprising:
applying a mixture of monomer and polymer to a patterned surface of an imprint template;
contacting the imprint template against a substrate; and
after contacting, illuminating the mixture of monomer and polymer with actinic radiation.

28. The method according to claim 27, wherein the mixture of monomer and polymer has a viscosity which is sufficiently high that it does not break up when it contacts the imprint template.

29. A method of imprint lithography, comprising:
applying an imprintable medium to a patterned surface of an imprint template;
applying a planarization layer to a surface of a substrate, both the imprintable medium and the planarization layer being fluids; and
after the applying, contacting the imprint template against the substrate.

30. The method according to claim 29, further comprising illuminating the imprintable medium and the planarization layer with actinic radiation, after the imprint template has contacted the substrate.
